# EUROPEAN PATENT APPLICATION

(11) **EP 2 696 510 A1**
(43) Date of publication of application: **12.02.2014**
(21) Application number: 13152473.8
(22) Date of filing: 24.01.2013
(51) Int. Cl.: H04B 1/38, H04M 1/04, G01R 1/04, A45F 5/00, H01F 7/02

(54) **Accessory mount assembly and methods of using same**

(30) Priority: 10.08.2012 US 201213572539
(71) Applicant: Fluke Corporation, Everett, WA 98203 (US)
(72) Inventor: Marzynski, Matthew, Seattle, WA Washington 98115 (US); Worones, Jeffrey Edward, Seattle, WA Washington 98122 (US)
(74) Representative: Schraud, Robert Alexander

(57) **Abstract**

In accordance with one embodiment of the present disclosure, an accessory mount (20) includes a receiving interface portion (24) on the accessory (10), and a mountable portion (22) magnetically couplable to the receiving interface portion. (24)

## Description

Today's work environment has become more mobile with the advancement of portable technologies. For example, a growing part of a mobile work environment is hand-held instruments, such as scanners and multimeters. Hand-held instruments generally include a casing for housing electronics and a probe operatively connected to the electronics by a cable. In operation, the operator typically holds the casing in one hand and the probe in the other hand to retrieve data for analysis on site or at a more convenient location. Such hand-held instruments bring technology into remote locations that otherwise may have been inaccessible.

Thus, the advancement of portable technology has lead to a more mobile work force by the use of instruments. Although portable instruments are convenient for their intended use, they are not without their problems.

One such problem of portable instruments is the cumbersome nature of the instrument itself. As noted above for hand-held instruments, operation of such instruments requires both hands of the operator. However, in certain applications, the operator may require one or both hands free to simultaneously operate another device and, therefore, needs a convenient location to place the instrument. In these situations, the operator has at least two options. First, the operator may place the instrument and probe into one hand while performing work with their free hand. Alternatively, the operator may place the instrument on the ground or place it on some structure located near the work area. Both options are undesirable because of increased risk of either dropping the probe or instrument, inadvertently stepping on the instrument, or distracting the operator's attention away from the secondary device.

Prior attempts at increasing the convenience and safety of using hand-held instruments have included attachment devices, such as strap hooks and holsters. Typically, strap hooks are fastened to the instrument casing and define a belt loop. The operator threads a belt through the belt loop, thereby strapping the instrument to their clothing. Although strap hooks are useful, they have limited utility because they are specifically adapted to be strapped to the body of the operator. Holsters for hand-held instruments are adapted to be carried on the shoulder of the operator. Such holsters include a pocket that is sized to cradle the instrument and a shoulder strap. The shoulder strap is attached to the pocket, such that the instrument may be hung from the shoulder of the operator. Holsters also have limited utility because they are not easily adaptable to accommodate other attachments to hang the instrument from an object other than the operator's body.

Thus, there exists a need for a relatively inexpensive, reliable, and convenient accessory mount capable of accommodating a variety of accessories in a variety of different ways. Embodiments of the present disclosure are directed to fulfilling this and other needs.

This summary is provided to introduce a selection of concepts in a simplified form that are further described below in the Detailed Description. This summary is not intended to identify key features of the claimed subject matter, nor is it intended to be used as an aid in determining the scope of the claimed subject matter.

In accordance with one embodiment of the present disclosure, an accessory mount assembly is provided. The assembly generally includes a receiving interface portion on the accessory, and a mountable portion magnetically couplable to the receiving interface portion.

In accordance with another embodiment of the present disclosure, an accessory mount assembly is provided. The assembly generally includes a receiving interface portion on the accessory, and a mountable portion magnetically couplable to the receiving interface portion, wherein the mountable portion is stopped from sliding movement relative to the receiving interface portion.

In accordance with one embodiment of the present disclosure, a method of mounting an accessory using an accessory mount assembly is provided. The method generally includes obtaining an accessory mount assembly including a receiving interface portion and a mountable portion magnetically couplable to the receiving interface portion, and hanging the accessory from an object using the accessory mount assembly.

Further embodiments of the disclosure are as follows:

An accessory mount assembly, the assembly comprising: (a) a receiving interface portion on the accessory; and (b) a mountable portion magnetically couplable to the receiving interface portion.

For example, the receiving interface portion includes a lateral stop configured to prevent sliding movement of the mountable portion relative to the receiving interface portion.

According to an embodiment the lateral stop includes a plurality of stents.

For example, the receiving interface portion is associated with a first slot.

For instance, the first slot extends through the housing of the accessory.

According to an embodiment the mountable portion is associated with a second slot.

The assembly may comprise a strap configured to be received within at least one of the first and second slots.

According to an embodiment at least one of the receiving interface portion and the mountable portion includes a magnet.

For example, the other of the receiving interface portion and the mountable portion is capable of magnetic attraction with a magnet.

According to an embodiment the mountable portion includes a first side and a second side, and wherein both the first and second sides are capable of magnetic attraction.

The assembly may further comprise a housing extension.

For example, the housing extension is coplanar with an external surface of the mountable portion.

An accessory mount assembly, the assembly comprising: (a) a receiving interface portion on the accessory; and (b) a mountable portion magnetically couplable to the receiving interface portion, wherein the mountable portion is stopped from sliding movement relative to the receiving interface portion.

A method of mounting an accessory using an accessory mount assembly, the method comprising: (a) obtaining an accessory mount assembly including a receiving interface portion and a mountable portion magnetically couplable to the receiving interface portion; and (b) hanging the accessory from an object using the accessory mount assembly.

For example, hanging the accessory from an object includes magnetically coupling the mountable portion to the receiving interface portion and magnetically coupling the mountable portion to the object.

For example, hanging the accessory from an object includes non-magnetically coupling the mountable portion to the receiving interface portion and magnetically coupling the mountable portion to the object.

According to an embodiment the mountable portion is coupled to the receiving interface portion using a strap.

For example, hanging the accessory from an object includes magnetically coupling the mountable portion to the receiving interface portion and non-magnetically coupling the mountable portion to the object.

According to an embodiment the mountable portion is coupled to the object using a strap.

The foregoing aspects and many of the attendant advantages of this disclosure will become more readily appreciated as the same become better understood by reference to the following detailed description, when taken in conjunction with the accompanying drawings, wherein:
FIGURE 1 is a front isometric view of an instrument including an instrument mount assembly in accordance with embodiments of the present disclosure;
FIGURE 2 is a back isometric view of the instrument of FIGURE 1, showing the instrument mount assembly in a first mounting configuration;
FIGURE 3 is an exploded view of the instrument mount assembly of FIGURE 2;
FIGURES 4 and 5 are front and back isometric views of the instrument of FIGURE 1, showing the instrument mount assembly in a second mounting configuration; and
FIGURES 6 and 7 are front and back isometric views of the instrument of FIGURE 1, showing the instrument mount assembly in a third mounting configuration.

The detailed description set forth below in connection with the appended drawings, where like numerals reference like elements, is intended as a description of various embodiments of the disclosed subject matter and is not intended to represent the only embodiments. Each embodiment described in this disclosure is provided merely as an example or illustration and should not be construed as preferred or advantageous over other embodiments. The illustrative examples provided herein are not intended to be exhaustive or to limit the disclosure to the precise forms disclosed. Similarly, any steps described herein may be interchangeable with other steps, or combinations of steps, in order to achieve the same or substantially similar result.

In the following description, numerous specific details are set forth in order to provide a thorough understanding of exemplary embodiments of the present disclosure. It will be apparent to one skilled in the art, however, that many embodiments of the present disclosure may be practiced without some or all of the specific details. In some instances, well-known process steps have not been described in detail in order not to unnecessarily obscure various aspects of the present disclosure. Further, it will be appreciated that embodiments of the present disclosure may employ any combination of features described herein.

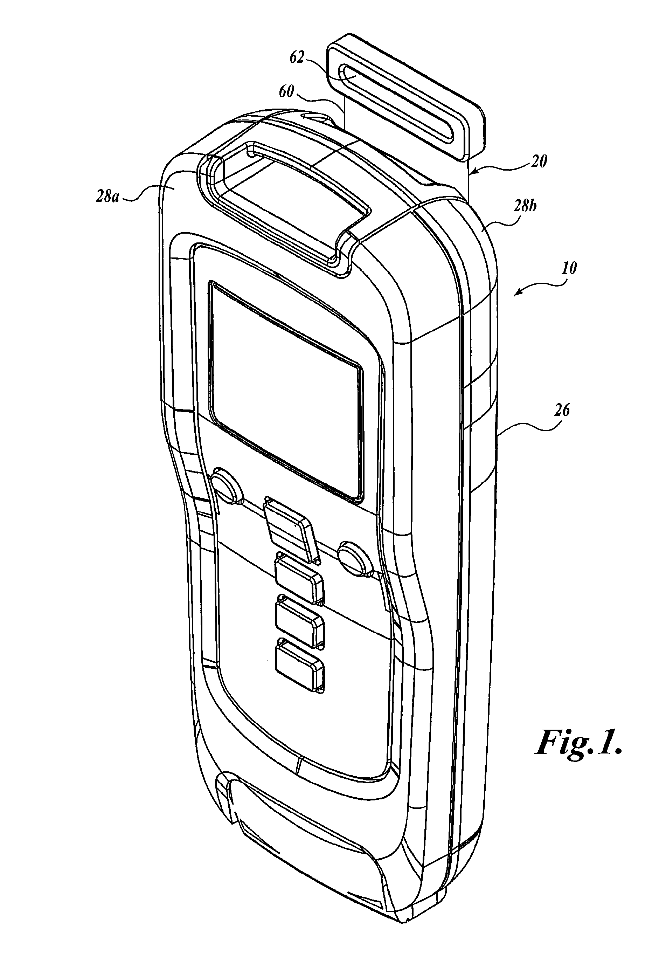

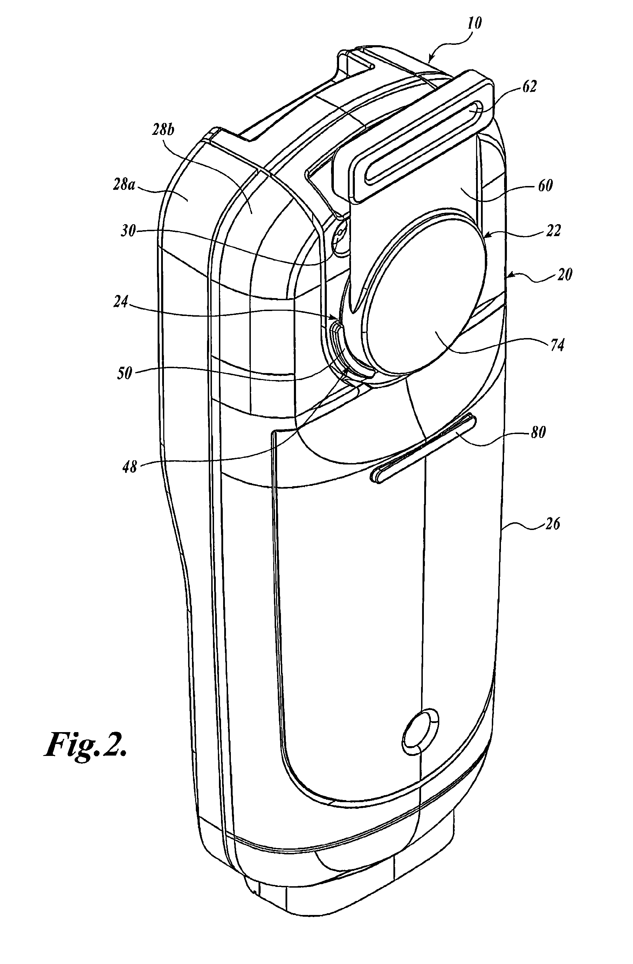

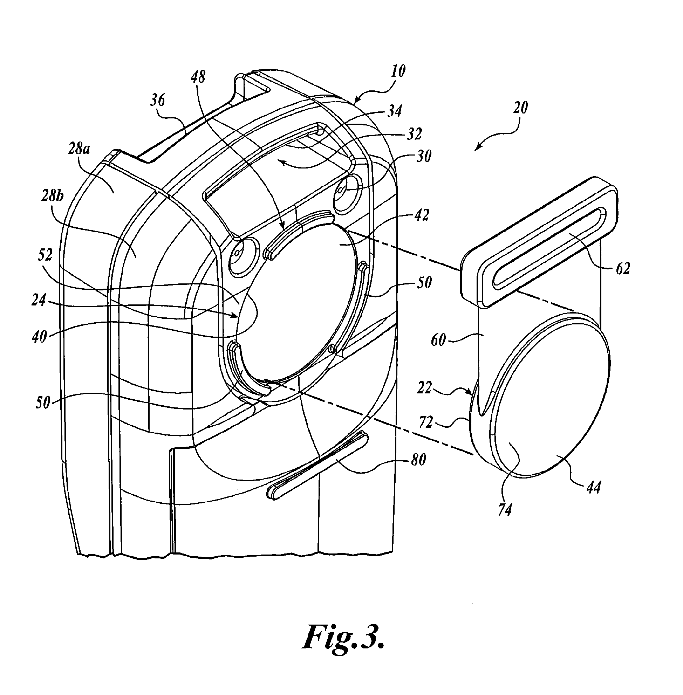

Embodiments of the present disclosure are generally directed to accessory mount assemblies and methods, for example, for mounting accessories, such as instruments. Referring to FIGURES 1-3, an accessory mount assembly 20 for a portable or handheld instrument 10 constructed in accordance with one embodiment of the present disclosure is provided. The accessory mount assembly 20 includes a mountable portion 22 and a receiving interface portion 24. Referring to FIGURES 1 and 2, the accessory mount assembly 20 is shown in an assembled configuration, as it would be attached to a portable instrument 10. Referring to FIGURE 3, the accessory mount assembly 20 is shown in a disassembled configuration, as it would be detached from the portable instrument 10.

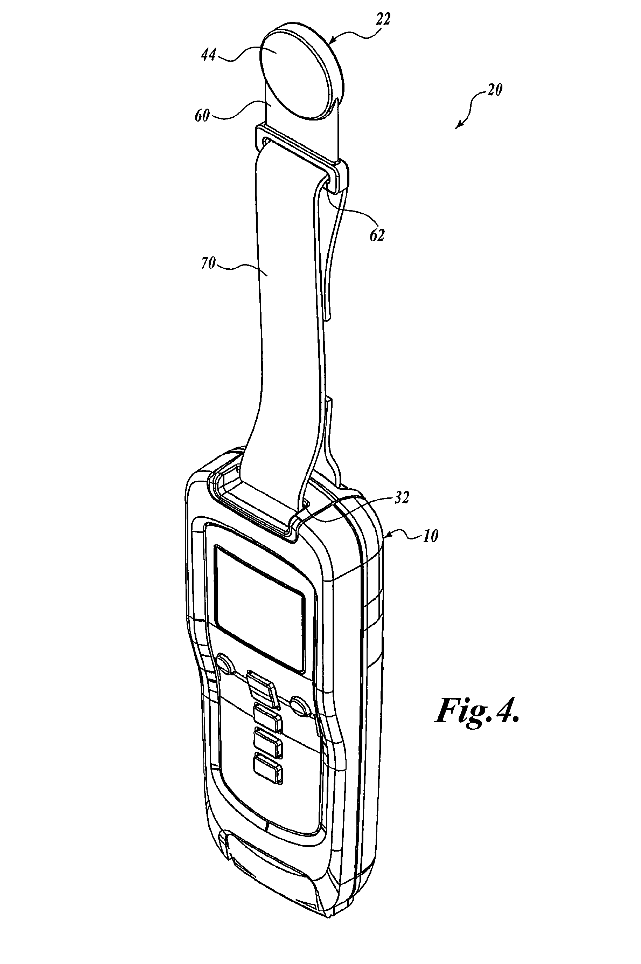

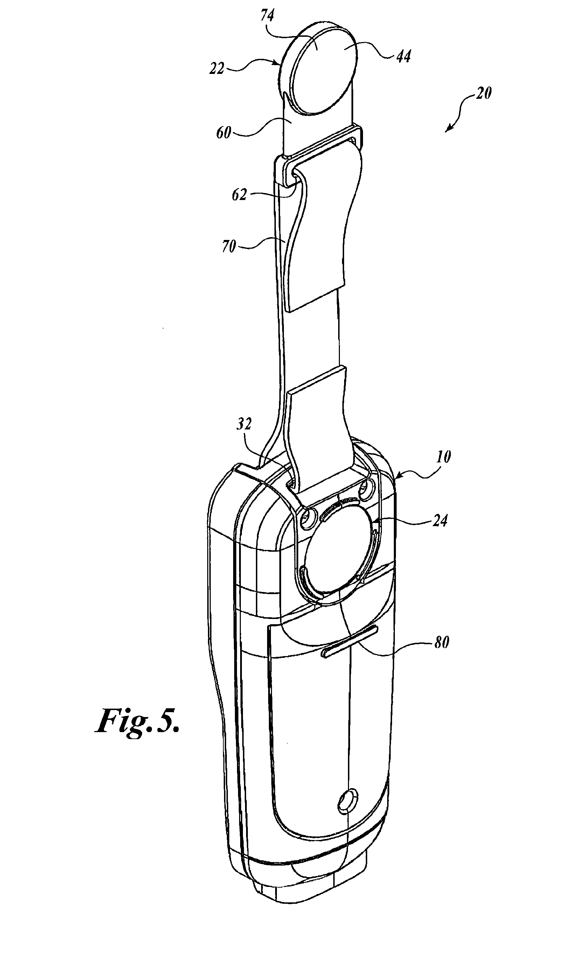

Although shown in the illustrated embodiment as an accessory mount assembly for handheld (e.g., portable) instruments, it should be appreciated that the assemblies and methods described herein may be used for any mounting application. Although the use of a mountable portion 22 is within the scope of the present disclosure, mountable portion 22 is not required to be attached to the receiving interface portion 24 for the instrument to be mountable (see, e.g., FIGURES 4 and 5), as is described in greater detail below.

In accordance with one embodiment of the present disclosure, one of the mountable portion 22 and the receiving interface portion 24 is a magnetic body, i.e., either a magnet or a material capable of magnetic attraction (e.g., a ferrous material or another magnetic material), so that the two portions interact by magnetic attraction. Therefore, the mountable portion 22 and the receiving interface portion 24 are configured to be attachable to one another in a variety of attachment configurations (see, e.g., FIGURES 2-7), as is described in greater detail below. Moreover, the mountable portion 22 and the receiving interface portion 24 may further include other receiving portions (for example, respective slots 32 and 62 for receiving straps or belts) to further allow for other attachment configurations, as is described in greater detail below.

The instrument 10 of the illustrated embodiment may be any well-known portable instrument, such as a scanner or hand-held test equipment. In the illustrated embodiment, the housing assembly 26 for the instrument 10 is rounded, so as to be comfortably held in the hand of a user. Because it can sometimes be difficult to attach rounded surfaces to surfaces or objects, such as a wall or surface of a machine, (particularly using magnetic attachment means, as described in greater detail below) the accessory mount assembly 20 may include substantially planar surfaces. In the illustrated embodiment, the accessory mount assembly, including the mountable portion 22 and the receiving interface portion 24 may have surfaces that are substantially planar, rather than being rounded like the other surfaces of the instrument 10.

As seen in the illustrated embodiment of FIGURES 1-3, the instrument 10 includes a two-part housing assembly 26 that includes first and second housing casings 28a and 28b. The casings 28a and 28b may be manufactured according to any suitable manufacturing process. For example, they may be injection-molded from a thermoplastic and are fastened together by well-known fasteners (not shown), such as snap fasteners or screws (see e.g., screws 30 in FIGURE 3). The casings 28a and 28b are configured and are sized to house the internal hardware (not shown), such as electronics, of the instrument 10 when the casings 28a and 28b are fastened together.

Referring to FIGURE 4, the housing assembly 26 is configured to be hangable, for example, from a strap 70 or another suitable tethering line. In the illustrated embodiment, the housing assembly 26 includes a hanging device receiving portion, shown as slot 32 for receiving such a strap 70. In the illustrated embodiment, the first and second housing casings 28a and 28b are designed and configured to be molded to include first and second hole portions 34 and 36, which when joined form a slot 32, for example, for receiving the strap 70. However, it should be appreciated that the slot 32 may be formed in any suitable portion or position of the housing assembly 26, for example, in only one of the first or second housing casings 28a or 28b, or in a separately formed part that is attached to the housing assembly 26.

As seen in the illustrated embodiment, slot 32 is oblong in shape and is sized to receive an accessory (not shown) therethrough, such as a belt or a strap, as is described in greater detail below. However, it should be appreciated that other shapes and configurations for a hanging device receiving portion are within the scope of the present disclosure. For example, a suitable hanging device receiving portion may be a hole or a hook configured for receiving a string or wire.

In addition to strap hangable means, the housing assembly 26 is further configured for magnetic attachment with, for example, the mountable portion 22 of the accessory mounting assembly 20. In that regard, the second housing casing 28b of the illustrated embodiment is designed and configured to include the receiving interface portion 24 of the accessory mount assembly 20. The second housing casing 28b is molded to include an area 40 for receiving a first magnetic portion 42 that may be inset in the area 40. The first magnetic portion 42 is a magnetic body, which may be either a magnet or a component capable of magnetic attraction for mating with a second magnetic portion 44 in mountable portion 22.

In the illustrated portion, area 40 for receiving the first magnetic portion 42 is a well area in the second housing casing 28b, in which the first magnetic portion 42 is inset to lie flush with the outer surface of the second housing casing 28b. However, it should be appreciated, that the first magnetic portion 42 may be disposed within the wall of the second housing casing 28b or beneath a cover portion (for example, a plastic or rubber covering for the first magnetic portion 42). Moreover, it should be appreciated that the first magnetic portion 42 need not lie flush with the outer surface of the second housing casing 28b, and may be embedded below the outer surface of the second housing casing 28b to create an internal edge, or may extend (at least partially) from the outer surface of the second housing casing 28b.

Extending around at least a portion of the outer perimeter of the area 40 is a lateral stop. As a non-limiting example in the illustrated embodiment, the lateral stop 48 is configured as a plurality of stents 50 surrounding the area 40. Because of the low shear strength of magnetic attachments, the stents 50 are intended to create a recess for receiving the mountable portion 22 and to prevent lateral or sliding movement of the mountable portion 22 relative to the instrument 10 when it is magnetically coupled to the receiving interface portion 24 of the accessory mount assembly 20.

In other embodiments of the present disclosure, a suitable lateral stop may be the edge at the outer surface of the second housing casing 28b if the first magnetic portion is embedded below the outer surface of the second housing casing 28b. Moreover, the lateral stop may also be configured as a continuous wall, and not just surrounding a portion of the outer perimeter, or a plurality of raised bumps, or any other suitable configuration to prevent lateral or sliding movement of the mountable portion 22 relative to the instrument 10 when it is magnetically coupled to the receiving interface portion 24 of the accessory mount assembly 20.

In the illustrated embodiment, the lateral stop 48 extends from the housing casing 28b, but is sized in extension height to not extend beyond the outer surface of the mountable portion 22 (when coupled). Therefore, the outer surface 74 of the mountable portion 22 is able to form a strong magnet bond with an object or surface to which is attaches without interference from the lateral stop 48. However, it should be appreciated that lateral stops that extend beyond the outer surface 74 of the mountable portion 22 or have an outer edge that is co-planar with the outer surface 74 of the mountable portion 22 are within the scope of the present disclosure.

In the illustrated embodiment, the stents 50 include spacing between adjacent stents 50. The spacing 52 between adjacent stents 50, allows the user to fit his or her fingers against the outer perimeter surface of the second magnetic portion 44 when either coupling the first and second magnetic portions 42 and 44 together or when decoupling them from each other.

Although illustrated as a circular first magnetic portion 42 for mating with a circular second magnetic portion 44, it should be appreciated that the magnetic portions may be of any shape. Likewise, the outer perimeter of the recessed area 40 may include a lateral stop (or stents) that would complement the chosen shape.

Still referring to FIGURE 3, the mountable portion 22 will now be described in greater detail. As mentioned above, the mountable portion 22 includes the second magnetic portion 44 for interfacing with the first magnetic portion 42 contained within the receiving interface portion 24. In the illustrated embodiment, the second magnetic portion 44 is circular in shape to correspond with the lateral stop 48 (shown as stents 50) defining the interface area between the first and second magnetic portions 42 and 44.

In the illustrated embodiment, the mountable portion 22 further includes an extension portion 60 including a slot 62 for receiving a strap or a belt. Like slot 32 described above, it should be appreciated that other shapes and configurations for a hanging device receiving portion are within the scope of the present disclosure. For example, a suitable hanging device receiving portion may be a hole or a hook configured for receiving a string or wire.

In the illustrated embodiment, the extension portion 60 has a thickness that is less than the thickness of the second magnetic portion 44 and extends from a position that is substantially centered between first and second surfaces 72 and 74 of the second magnetic portion 44. In that regard, the extension portion 60 does not interfere with lateral stop 48 to affect the coplanar coupling of the first surface 72 of the second magnetic portion 44 and the visible surface of the first magnetic portion 42.

As can be seen in the illustrated embodiment, the extension portion 60 is oriented upward relative to the instrument 10 when the mountable portion 22 is received by the receiving interface portion 24. However, it should be appreciated, that the mountable portion 22 may also be oriented relative to the receiving interface portion 24 such that the extension portion 60 and slot 62 extend at an angle, sideways, or downward relative to the instrument 10 (see, e.g., FIGURES 4 and 5). In that regard, the lateral stop 48 is configured to enable various mounting positions. Moreover, the three stents 50 of the lateral stop 48 in a tripod configuration provide consistent stopping resistance regardless of the orientation of the mountable portion 22 relative to the interface portion 24.

In the illustrated embodiment, the instrument 10 is designed such that at least a portion of the outer surface of the mountable portion 22 is coplanar with the housing 26 of the instrument 10. In that regard, when the instrument 10 (with mountable portion 22 attached) is positioned against a surface, such as a wall or when on a desk, rotational movement of the instrument 10 relative to the surface (for example, due to a rounded housing casing 28b) may cause magnetic detachment from the surface. Therefore, housing extension 80 extending from the second housing casing 28b provides a second planar surface for stabilizing the instrument 10 against a surface or object. In that regard, housing extension 80 is coplanar with the outer surface 74 of the second magnetic portion 44 to provide two planes of contact against a surface or object for instrument 10 stabilization. In the illustrated embodiment, the housing extension 80 is positioned below the receiving interface portion 24 on the housing casing 28b; however, it should be appreciated that the housing extension 80 may be suitable located anywhere on the housing casing 28b so as to provide a stabilizing effect. Moreover, any number of housing extensions 80 are within the scope of the present disclosure.

Instrument stabilization may also be achieved using at least two points of contact on the housing 26, or at least three points of contact on the housing 26 that are coplanar. Moreover, for small instruments having a high magnet surface area to instrument ratio, the strength of the magnet may provide suitable stabilization so as not to require a housing extension 80 to provide a second plane of contact or a lateral stop 48 (such as stents 50) to prevent lateral or sliding movement of the mountable portion 22 relative to the receiving interface portion 24. Such a configuration is dependent upon the size of the magnet, the strength of the magnet, and the relationship is size and strength as compared to the size and weight of the instrument 10.

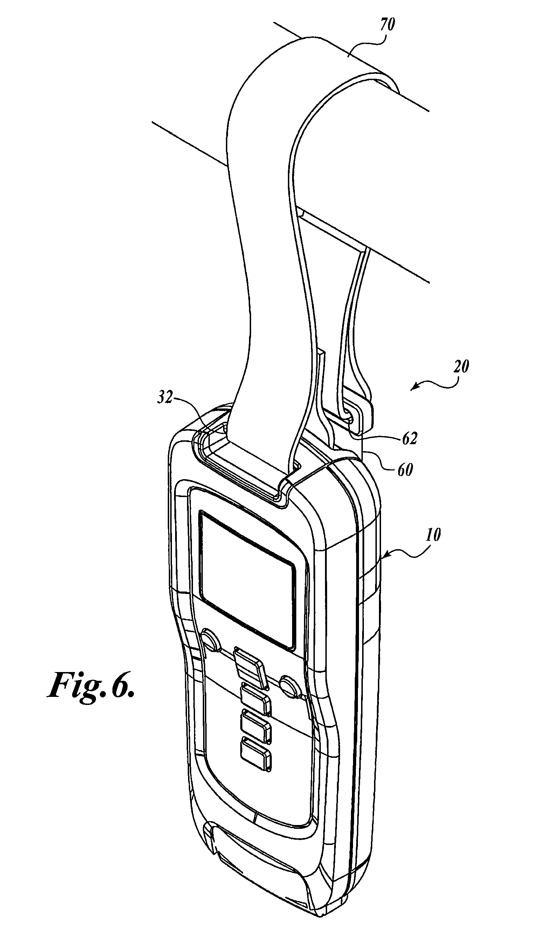

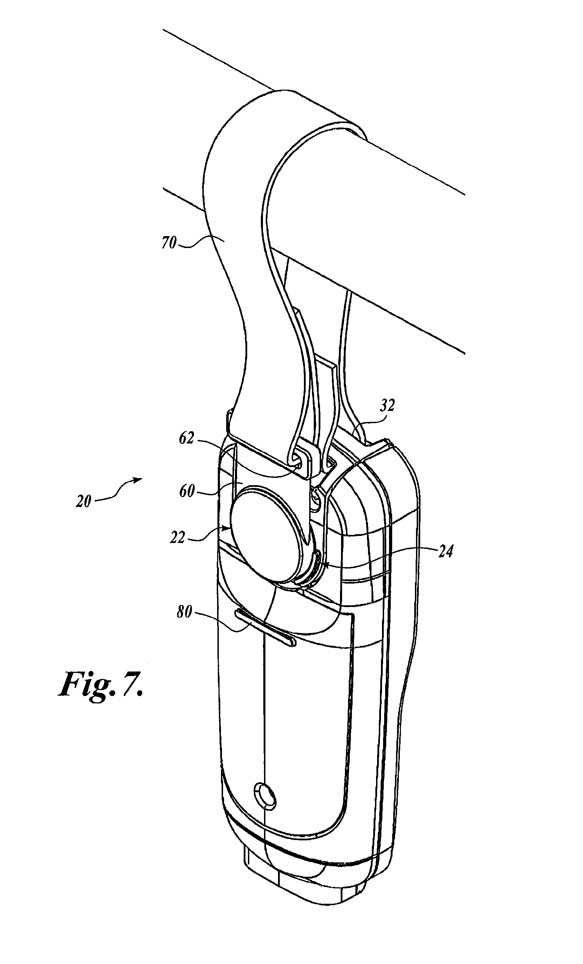

Operation of an accessory mount assembly 20 formed in accordance with one embodiment of the present disclosure may be best understood by referring to FIGURES 2-7. The accessory mount assembly 20 is positionable in a plurality of different use configurations, as shown, respectively, in FIGURES 2 and 3 (direct magnetic attachment of the instrument to an object, wherein the mountable portion and the receiving interface portion are magnetically coupled and the outer surface of the mountable portion is magnetically coupled to an object), FIGURES 4 and 5 (indirect magnetic attachment of the instrument to an object, wherein the mountable portion and the receiving interface portion are non-magnetically coupled and the outer surface of the mountable portion is magnetically coupled to an object), and FIGURES 6 and 7 (non-magnetic attachment of the instrument to an object, wherein the mountable portion and the receiving interface portion are magnetically coupled and the instrument is non-magnetically coupled to an object), each of which will now be described in detail.

First, referring to FIGURES 2 and 3, a configuration for direct magnetic affixation of the instrument 10 is provided. In that regard, the second magnetic portion 44 of the mountable portion can be coupled to the first magnetic portion 42 of the receiving interface portion 24 by placing the two magnetic portions 42 and 44 in near vicinity to each other. When received, the second magnetic portion 44 fits within the stents 50 surrounding the outer portion of the first magnetic portion 42, which thereby prevent sliding movement of the second magnetic portion 44 relative to the first magnetic portion 42.

At discussed above, either of the first or second magnetic portions 42 or 44 may be magnetic (with the other being a material capable of magnetic attraction). In a preferable embodiment, the second magnetic portion 44 is a magnet. Therefore, the outer surface 74 of the second magnetic portion 44 can be used to magnetically attach directly to another surface capable of magnetic attraction. In this manner, the instrument 10 can couple directly with a surface that is capable of magnetic attraction and mating with the second magnetic portion 44.

To remove the mountable portion 22 from the receiving interface portion 24, the second magnetic portion 44 is simply uncoupled from the first magnetic portion 42.

Second, referring to FIGURES 4 and 5, a method of indirect magnetic affixation of the instrument 10 is provided. In that regard, a strap or belt 70 is fed through slot 32 in the housing assembly 26 of the instrument 10. The mountable portion 22 is decoupled from the receiving interface portion 24 of the assembly mount assembly 20, and the same strap 70 is fed through the slot 62 of the extension section 60 of the mountable portion 22. By using the strap 70, the outer surface 74 of the mountable portion 22 can be magnetically coupled to a surface, while the instrument 10 hangs on the strap 70 from the attachment point.

Third, referring to FIGURES 6 and 7, a method of indirect non-magnetic affixation of the instrument 10 is provided. In that regard, the mountable portion 22 is magnetically coupled to the receiving interface portion 24 (similar to the configuration shown in FIGURES 1-3). However, a strap 70 is used to hang the instruction 10 by looping the strap through both the first slot 32 and the second slot 62. Therefore, the instrument 10 hangs using a non-magnetic affixation method.

As seen in the illustrated embodiment of FIGURES 4-7, the strap 70 is configured to couple to itself to form two loops through the slots 32 and 62. The strap 70 self-attachment mechanism may be by hook-and-loop fasteners, snaps, buttons, or any other type of suitable fastener. However, it should be appreciated that the strap or belt may be configured to form a single loop by attaching at its two ends via a buckle or another suitable attachment mechanism. Further, the strap may include a jam stop to allow only unidirectional travel of the strap through the slots 32 and 62.

Moreover, straps 70 and slots 32 and 62 may be sized and configured to varying dimensions depending on the application. In one embodiment, the strap 70 may be a one-inch wide nylon webbing strap. In another embodiment, the strap 70 may be a 0.5-inch wide nylon webbing strap. In another embodiment, the strap may be integrated into the mountable portion 22. For example, the strap 70 may be a rubber strap with the magnet molded inside the strap.

The previously described version of the present disclosure provides several advantages over accessory mounts currently available. First, the accessory mount assembly 20 of the present disclosure permits convenient probe storage of an instrument when the probes are not in use. Second, the accessory mount assembly 20 of the present disclosure is adapted to couple directly to an object, or to attach a variety of accessories, such as a strap or belt, to the instrument, such that the instrument may be hung from a variety of objects of the operator's choice. Such accessories permit operation of the instrument without requiring the use of both hands of the operator.

From the foregoing description, it may be seen that an accessory mount assembly formed in accordance with embodiments of the present disclosure incorporates many novel features and offers significant advantages over those currently available. While illustrative embodiments have been illustrated and described, it will be appreciated that various changes can be made therein without departing from the spirit and scope of the disclosure. Therefore, the illustrated and described embodiment is to be considered as exemplary only and the disclosure itself should be evaluated only as defined in the claims that follow.

## Claims

1. An accessory mount assembly, the assembly comprising:
(a) a receiving interface portion on the accessory; and
(b) a mountable portion magnetically couplable to the receiving interface portion.

2. The assembly of Claim 1, wherein the mountable portion is stopped from sliding movement relative to the receiving interface portion, particularly wherein the receiving interface portion includes a lateral stop configured to prevent sliding movement of the mountable portion relative to the receiving interface portion.

3. The assembly of Claim 2, wherein the lateral stop includes a plurality of stents.

4. The assembly of one of Claims 1-3, wherein the receiving interface portion is associated with a first slot, and/or the mountable portion is associated with a second slot.

5. The assembly of Claim 4, wherein the first slot extends through the housing of the accessory.

6. The assembly of Claim 4 or 5, further comprising a strap configured to be received within at least one of the first and second slots.

7. The assembly of one of Claims 1-6, wherein at least one of the receiving interface portion and the mountable portion includes a magnet.

8. The assembly of Claim 7, wherein the other of the receiving interface portion and the mountable portion is capable of magnetic attraction with a magnet.

9. The assembly of one of Claims 1-8, wherein the mountable portion includes a first side and a second side, and wherein both the first and second sides are capable of magnetic attraction.

10. The assembly of one of Claims 1-9, further comprising a housing extension.

11. The assembly of Claim 10, wherein the housing extension is coplanar with an external surface of the mountable portion.

12. A method of mounting an accessory using an accessory mount assembly, the method comprising:
(a) obtaining an accessory mount assembly including a receiving interface portion and a mountable portion magnetically couplable to the receiving interface portion; and
(b) hanging the accessory from an object using the accessory mount assembly.

13. The method of Claim 12, wherein hanging the accessory from an object includes magnetically coupling the mountable portion to the receiving interface portion and magnetically or non-magnetically coupling the mountable portion to the object.

14. The method of Claim 12, wherein hanging the accessory from an object includes non-magnetically coupling the mountable portion to the receiving interface portion and magnetically coupling the mountable portion to the object.

15. The method of one of Claims 12-14, wherein the mountable portion is coupled to the receiving interface portion using a strap and/or to the object using a strap.
